# FASCICULE DE BREVET EUROPEEN

(11) **EP 0 493 271 B1**
(45) Date de publication et mention de la délivrance du brevet: **18.10.1995**
(21) Numéro de dépôt: 91420443.3
(22) Date de dépôt: 11.12.1991
(51) Int. Cl.: G01R 15/06, G01R 19/00, G01R 27/18

(54) **Pont de mesure de tension de référence pour dispositif de contrôle et de mesure de l'isolement d'un réseau électrique à tension continue**
Messbrücke für Referenzspannung für Gerät zur Überwachung und Messung der Isolation eines elektrischen Gleichspannungsnetzes
Measuring bridge for reference voltage for a device for monitoring and measuring the insulation of a DC electric network

(30) Priorité: 26.12.1990 FR 9016404
(43) Date de publication de la demande: 01.07.1992
(73) Titulaire: SCHNEIDER ELECTRIC SA, 92100 Boulogne Billancourt (FR)
(72) Inventeur: Pellegrin, Christian, F-38050 Grenoble Cedex (FR); Weynachter, Luc, F-38050 Grenoble Cedex (FR); Allin, Patrice, F-38050 Grenoble Cedex (FR)
(74) Mandataire: Hecké, Gérard

(56) Documents cités:
- EP-A- 0 398 824
- US-A- 2 613 345
- JOURNAL OF PHYSICS E. SCIENTIFIC INSTRUMENTS. vol. 10, no. 1, Janvier 1977, ISHING, BRISTOL GB pages 71 - 72; H.-P. RUST ET AL.: 'CAPACITIVE MEASUREMENTS OF SLOW FLUCTUATIONS IN HIGH-VOLTAGE SUPPLIES FOR'
- IEEE TRANSACTIONS ON INSTRUMENTATION AND MEASUREMENT. vol. IM-26, no. 1, Mars 1977, NEW YORK US pages 46 - 52; P. A. MCGOVERN: 'NANOSECOND PASSIVE VOLTAGE PROBES'

## Description

La présente invention se rapporte à un pont de mesure de tension de référence pour dispositif de contrôle et de mesure de l'isolement d'un réseau électrique à tension continue, notamment d'un réseau à basse tension, par exemple de l'ordre de 600 volts, le pont de mesure de tension étant destiné à fournir au moins une portion du signal d'entrée utile d'une chaîne d'analyse de la tension alternative de référence, à basse fréquence, comprise entre 4 et 10 Hertz par exemple, et à faible tension, de l'ordre de 30 volts crête-à-crête par exemple, qui est injectée dans le réseau électrique continu.

Il est connu, par exemple des documents FR-A-2.616.228 et FR-A-2.647.220, d'utiliser pour le contrôle et la mesure de l'isolement d'un réseau électrique par rapport à la terre, un dispositif comprenant un circuit d'injection d'un signal alternatif de référence dans le réseau à surveiller, et un circuit électronique de détection apte à fournir un signal de mesure représentatif de l'état d'isolement du réseau en réponse à l'émission du signal de référence, cet état d'isolement s'illustrant par une impédance de fuite Zd formée par une résistance de fuite Rf connectée électriquement en parallèle sur un condensateur parasite Cf, dont la capacité dépend des caractéristiques du réseau.

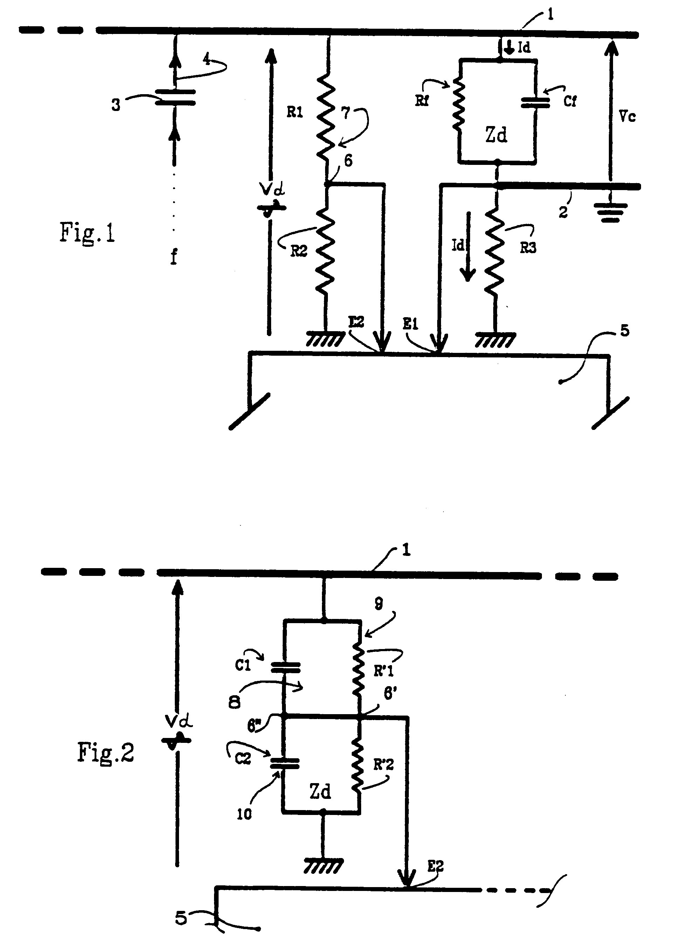

La figure 1 jointe représente schématiquement le circuit d'entrée d'un contrôleur d'isolement de l'art connu.

Il s'agit sur la figure 1 d'un réseau d'alimentation en tension continue Vc d'amplitude plutôt élevée, par exemple de 600 volts. La tension est appliquée entre un fil de ligne 1 et un fil de retour 2 qui est isolé de la masse de l'installation. L'impédance d'isolement Zd entre les deux fils d'alimentation continue 1 et 2 se compose de la résistance de fuite Rf et du condensateur parasite Cf, dont la capacité dépend des caractéristiques du réseau et qui, comme représenté, est en parallèle sur la résistance Rf.

Le contrôleur d'isolement, qui a pour but de surveiller les deux composantes Rf et Cf de l'impédance d'isolement Zd, comporte des moyens (non représentés) pour injecter, à travers un fil d'amenée 4 et un condensateur de couplage 3, une tension alternative de référence Vd entre le fil de ligne 1 et la masse de l'installation. Il s'agit d'une tension alternative à basse fréquence f, généralement comprise entre 4 et 10 Hertz, et dont la tension crête-à-crête est relativement faible, de l'ordre d'une trentaine de volts par exemple.

La détermination de la valeur résistive Rf et de la valeur capacitive Cf de l'impédance Zd nécessite la mesure de la valeur de tension d'injection Vd d'une part, et de celle du courant correspondant Id qui traverse l'impédance d'isolement Zd d'autre part.

Le courant Id est mesuré en prélevant la valeur de la tension à fréquence f qui est due à la circulation du courant Id dans une résistance de mesure R3 branchée en série avec l'impédance Zd, entre le fil de retour 2 et la masse. L'information est appliquée sur l'entrée E1 de l'organe 5 de traitement et d'affichage qui équipe le contrôleur d'isolement.

La tension Vd est mesurée,et appliquée sur une autre entrée E2 de l'organe 5, par prélèvement sur la prise de sortie potentiomètrique 6 d'un pont diviseur à deux résistances R1,R2, dont le rapport d'atténuation, qui est de l'ordre de 80 par exemple, et la résistance totale (R1 + R2), qui est de l'ordre de 600 kiloohms par exemple, sont choisis de manière à réaliser un compromis entre:
- la précision de mesure qui est d'autant plus grande que le rapport R2/R1 est élevé (forte tension alternative injectée à l'entrée E2) et que la résistance (R1 + R2) du pont 7 est faible (fort courant alternatif parcourant ce pont);
- l'impédance d'entrée du réseau continu qui ne doit pas être trop diminuée par la présence de ce pont 7;
- le niveau de tension continue subsistant au point de mesure 6, qui doit non seulement être inférieur à la tension de fonctionnement des composants semiconducteurs du bloc 5 (+ 15 Volts, - 15 Volts en général), mais encore ne pas être élevé par rapport à celui de la tension alternative d'injection prélevé au même point 6.

La solution décrite dans le document FR-A-2.647.220, qui consiste à insérer un condensateur entre la résistance R1 et le conducteur de ligne 1, crée un problème de déphasage parasite, susceptible de perturber la précision de mesure.

La réalisation d'un tel compromis dans le choix des valeurs des résistances R1 et R2 ne peut pas être totalement satisfaisante. En effet, I'impédance du pont 7 qui en résulte est jugée insuffisante, et le signal utile alternatif qui est prélevé au point milieu 6 est si faible qu'il est pratiquement noyé dans le bruit. Le résidu d'alimentation continue qui subsiste au point milieu 6 est beaucoup trop important, aussi bien en valeur de tension qu'en intensité de courant.

L'article paru dans "Journal of Physics E: Scientific Instruments, Vol. 10, N° 1, de Janvier 1977, pages 71-72", décrit un dispositif de mesure des fluctuations lentes d'une alimentation à haute tension utilisant un diviseur capacitif raccordé par son point milieu à un circuit amplificateur.

L'objet de l'invention consiste à améliorer la précision d'un pont mixte de mesure d'une tension alternative de référence pour un dispositif de contrôle et de mesure de l'isolement d'un réseau électrique à tension continue.

Le pont de mesure selon l'invention est caractérisé par un pont mixte comprenant :
- un diviseur résistif comprenant une première résistance connectée en série avec une deuxième résistance entre la ligne du réseau, et la masse,
- un diviseur capacitif ayant un premier condensateur connecté en série avec un deuxième condensateur entre la ligne du réseau et la masse,
- lesdits deux diviseurs étant branchés en parallèle, et possédant des points intermédiaires de sortie connectés entre eux, et reliés à une entrée de la chaîne d'analyse,
- ledit diviseur résistif ayant une résistance totale supérieure à l'impédance d'entrée du réseau, et un rapport de division de l'ordre de un millième,
- ledit diviseur capacitif ayant un rapport de division de l'ordre de un demi, et une impédance qui est négligeable à la fréquence du signal de référence Vd par rapport à la résistance la plus faible du diviseur résistif, tel que la valeur de la tension continue prélevée aux points intermédiaires de sortie du pont mixte est faible par rapport à la valeur de la tension alternative de référence prélevée sur la même sortie, tandis que l'impédance en courant continu du pont est élevée par rapport à l'impédance d'entrée du réseau continu.

L'invention sera bien comprise, et ses avantages et autres caractéristiques ressortiront, lors de la description suivante d'un exemple non limitatif de réalisation, en référence au dessin schématique annexé dans lequel :
- la figure 1, déjà décrite précédemment, illustre un dispositif selon l'art antérieur; et
- la figure 2 est une pont de mesure conformé à l'invention et utilisable dans un circuit d'entrée de contrôleur d'isolement semblable à celui faisant l'objet de la figure 1.

On reconnaît sur la figure 2 le fil de ligne 1 du réseau électrique continu, par exemple 600 Volts, dont on désire, à l'instar du dispositif selon la figure 1, déterminer l'impédance d'isolement au moyen de la tension alternative de référence Vd, par exemple de fréquence 4 Hertz et d'amplitude crête-à-crête de 30 Volts, laquelle est injectée dans le réseau continu, et de l'organe de traitement 5 dont le circuit d'entrée comporte un dispositif de mesure de courant Id parcourant l'impédance d'isolement Zd (voir figure 1), et le dispositif de mesure de la tension de référence Vd, qui fait l'objet de la présente invention, et qui est de ce fait seul représenté sur la figure 2. Le dispositif de mesure de la tension Vd est ici composé d'un pont mixte 8 qui est constitué par la mise en parallèle, avec réunion des deux points de sortie potentiomètrique respectifs 6′ et 6˝:
- d'un pont diviseur résistif 9 qui est composé, par exemple, d'une résistance R′1 de l'ordre de 100 Mégohms et d'une résistance R′2 de l'ordre de 100 kiloohms, de sorte que l'impédance totale (R′1 + R′2) du pont est très élevée par rapport à l'impédance d'entrée du réseau continu, qui est elle-même généralement de l'ordre de 1 à 2 Mégohms, tandis que le rapport de division est extrêmement faible, de l'ordre du millième;
- d'un pont diviseur capacitif 10 qui se compose de deux condensateurs électrochimiques C1 et C2 de forte capacité, cette dernière étant suffisante pour que l'impédance, à la fréquence 4 Hertz de la tension de référence Vd, de chacun des condensateurs C1 et C2 soit très faible par rapport à celle de la plus faible, R′2, des résistances du pont diviseur résistif 9; en outre, les capacités sont choisies pour conférer au pont 10 un rapport de division élevé. Dans l'exemple, il s'agit de condensateurs identiques de 10 microfarads, de sorte que leur impédance est d'environ 4 Kiloohms à la fréquence 4 Hertz (donc négligeable par rapport à la résistance R′2 qui a une valeur de 10 Kiloohms) et que le rapport de transformation du pont diviseur capacitif 10 est de un demi.

Le fonctionnement du circuit de mesure 8 est le suivant:

Pour le courant continu présent sur le fil de ligne 1, le pont capacitif 10 n'intervient pas, et, le rapport de division potentiomètrique du pont résistif 9 étant de un millième, la tension continue injectée au point E2 dans l'organe de traitement 5 est seulement de 0,6 volts, donc très faible.

En ce qui concerne la tension de référence à fréquence 4 Hertz, les résistances, respectivement R′1 et R′2, qui sont en parallèle sur les condensateurs C1 et C2, sont bien trop élevées pour influer par rapport à la capacitance de chacun des condensateurs, qui est d'environ 4 kiloohms. La tension alternative Vd ne "voit" donc que le pont diviseur capacitif, dont l'impédance totale est faible et dont le rapport de division (de un demi) est élevé. La tension alternative injectée au point E2 est donc élevée, de l'ordre de 15 volts crête-à-crête, et est très supérieure à la valeur précitée de 0,6 volts de la tension continue injectée au point E2, tandis que le courant alternatif injecté est également élevé en raison de la faible impédance totale (8 kiloohms environ) du pont.

## Revendications

1. Pont de mesure d'une tension alternative de référence (Vd) pour un dispositif de contrôle et de mesure de l'isolement d'un réseau électrique (1, 2) à tension continue (Vc), ledit dispositif comprenant :
- des moyens pour injecter un signal alternatif de référence (Vd) dans le réseau, ledit signal de référence ayant une fréquence de 4 à 10 Hz,
- le dispositif de mesure comprenant ledit pont de mesure de tension raccordé à une chaîne d'analyse (5) du signal de référence (Vd),
caractérisé en ce que ledit pont de mesure est formé par un pont mixte (8) comprenant :
- un diviseur résistif (9) comprenant une première résistance (R′1) connectée en série avec une deuxième résistance (R′2) entre la ligne (1) du réseau et la masse (2),
- un diviseur capacitif (10) ayant un premier condensateur (C1) connecté en série avec un deuxième condensateur (C2) entre la ligne (1) du réseau et la masse (2),
- lesdits deux diviseurs étant branchés en parallèle, et possédant des points intermédiaires de sortie (6′, 6˝) connectés entre eux, et reliés à une entrée (E2) de la chaîne d'analyse (5),
- ledit diviseur résistif (9) ayant une résistance totale supérieure à l'impédance d'entrée du réseau, et un rapport de division de l'ordre de un millième,
- ledit diviseur capacitif (10) ayant un rapport de division de l'ordre de un demi, et une impédance qui est négligeable à la fréquence du signal de référence (Vd) par rapport à la résistance la plus faible (R′2) du diviseur résistif (9), tel que la valeur de la tension continue prélevée aux points intermédiaires de sortie (6′, 6˝) du pont mixte (8) est faible par rapport à la valeur de la tension alternative de référence prélevée sur la même sortie, tandis que l'impédance (R′1 + R′2) en courant continu du pont (8) est élevée par rapport à l'impédance d'entrée du réseau continu.

2. Pont de mesure selon la revendication 1, caractérisé en ce que la résistance totale (R′1 + R′2) du diviseur résistif (9) est de l'ordre de la centaine de Mégohms, et que les capacités de chacun des deux condensateurs (C1, C2) du diviseur capacitif (10) sont de l'ordre de la dizaine de microfarads.

## Patentansprüche

1. Brückenschaltung zur Messung einer Prüfwechselspannung (Vd) für eine Anordnung zur Überwachung und Messung der Isolation eines mit Gleichspannung (Vc) betriebenen Netzes (1,2), wobei die genannte Anordnung
- Mittel zur Einleitung eines Prüfwechselsignals (Vd) mit einer Frequenz von 4 bis 10 Hz in das Netz umfaßt und
- die die genannte Spannungsmeßbrücke umfassende Meßanordnung mit einer Schaltung (5) zur Auswertung des Prüfsignals (Vd) verbunden ist,
dadurch gekennzeichnet, daß die genannte Meßbrücke als gemischte Meßbrücke (8) ausgeführt ist, die
- einen ohmschen Spannungsteiler (9) mit einer zwischen den Netzleiter (1) und Masse (2) geschalteten Reihenschaltung aus einem ersten Widerstand (R′1) und einem zweiten Widerstand (R′2) sowie
- einen kapazitiven Spannungsteiler (10) mit einer zwischen den Netzleiter (1) und Masse (2) geschalteten Reihenschaltung aus einem ersten Kondensator (C1) und einem zweiten Kondensator (C2) umfaßt,
- wobei die beiden Spannungsteiler zueinander parallelgeschaltet sind und Zwischenabgriffsausgänge (6′, 6˝) aufweisen, die miteinander verbunden und an einen Eingang (E2) der Auswertungsschaltung (5) angeschlossen sind,
- der genannte ohmsche Spannungsteiler (9) einen über der Eingangsimpedanz des Netzes liegenden Gesamtwiderstand und ein Teilungsverhältnis von etwa einem Tausendstel aufweist
- und der genannte kapazitive Spannungsteiler (10) ein Teilungsverhältnis von etwa 0,5 sowie eine bei der Frequenz des Prüfsignals (Vd) im Vergleich zum kleinsten Widerstand (R′2) des ohmschen Spannungsteilers (9) vernachlässigbare Impedanz aufweist, derart daß die Höhe der an den Zwischenabgriffsausgängen (6′, 6˝) der gemischten Meßbrücke (8) abgegriffenen Gleichspannung im Verhältnis zur Höhe der am gleichen Ausgang abgegriffenen Prüfwechselspannung klein, während die Gleichstromimpedanz (R′1 + R′2) der Meßbrücke (8) im Verhältnis zur Eingangsimpedanz des Gleichspannungsnetzes groß ist.

2. Meßbrücke nach Anspruch 1, dadurch gekennzeichnet, daß der Gesamtwiderstand (R′1 + R′2) des ohmschen Spannungsteilers (9) etwa einhundert Megohm und die Kapazität jedes der beiden Kondensatoren (C1, C2) des kapazitiven Spannungsteilers (10) etwa zehn Mikrofarad betragen.

## Claims

1. A measuring bridge of a reference AC voltage (Vd) for a device for monitoring and measuring the insulation of an electrical mains system (1,2) with DC voltage (Vc), said device comprising :
- means to input a reference AC signal (Vd) to the mains system, said reference signal having a frequency of 4 to 10 Hz,
- the measuring device comprising said voltage measuring bridge connected to an analysis channel (5) of the reference signal (Vd),
characterized in that said measuring bridge is formed by a mixed bridge (8) comprising :
- a resistive divider (9) comprising a first resistance (R′1) connected in series with a second resistance (R′2) between the mains system line (1) and ground (2),
- a capacitive divider (10) having a first capacitor (C1) connected in series with a second capacitor (C2) between the mains system line (1) and ground (2),
- said two dividers being connected in parallel, and having intermediate output points (6′, 6˝) connected to one another and connected to an input (E2) of the analysis channel (5),
- said resistive divider (9) having a total resistance greater than the input impedance of the mains system, and a dividing ratio of about one thousandth,
- said capacitive divider (10) having a dividing ratio of about one half, and an impedance which is negligible at the frequency of the reference signal (Vd) with respect to the lower resistance (R′2) of the resistive divider (9), such that the value of the DC voltage measured at the intermediate output points (6′, 6˝) of the mixed bridge (8) is low with respect to the value of the reference AC voltage measured on the same output, whereas the DC impedance (R′1 + R′2) of the bridge (8) is high with respect to the input impedance of the DC mains system.

2. The measuring bridge according to claim 1, characterized in that the total resistance (R′1 + R′2) of the resistive divider (9) is about one hundred Megaohms, and that the capacities of each of the two capacitors (C1, C2) of the capacitive divider (10) are about ten microfarads.
